# DEMANDE DE BREVET EUROPEEN

(11) **EP 4 697 332 A1**
(43) Date de publication de la demande: **18.02.2026**
(21) Numéro de dépôt: 25195065.5
(22) Date de dépôt: 11.08.2025
(51) Int. Cl.: G11C 11/16, G11C 11/18, H10B 61/00, H10N 50/10

(54) **MEMOIRE MAGNETO-RESISTIVE AVEC SELECTEURS INTEGRES**

(30) Priorité: 13.08.2024 FR 2408895
(71) Demandeur: Commissariat à l'Energie Atomique et aux Energies Alternatives, 75015 Paris (FR)
(72) Inventeur: VIALA, Bernard, 38054 GRENOBLE Cedex 09 (FR); LY, Denys, 38054 GRENOBLE Cedex 09 (FR)
(74) Mandataire: Atout PI Laplace

(57) **Abrégé**

L'invention concerne une cellule mémoire magnéto-résistive comprenant :
- un pilier (MTJ) formant une jonction tunnel magnétique (MTJ) et une piste d'écriture (SOT) en un matériau à effet Hall de spin ou un matériau à effet Hall orbital ;
- une couche support (14) en un matériau présentant une transition métal-isolant configurable ;
- une première électrode (EL1) disposée sur la couche support (14) ; la partie (143) de la couche support (14) confinée entre la première électrode (EL1) et la piste d'écriture (SOT) formant un premier sélecteur (S1) ;
- une seconde électrode (EL2) disposée sur la couche support (14); la partie (144) de la couche support (14) confinée entre la seconde électrode (EL2) et la piste d'écriture (SOT) formant un second sélecteur (S2).

## Description

### Champ d'application

La présente invention concerne le domaine de la conception de circuits de mémoires non-volatile et plus particulièrement les cellules mémoires magnéto-résistive à couple de spin-orbite ou à effet Hall Orbital, l'implémentation de matrices mémoires denses et leur programmation en lecture et en écriture.

### Problème technique

La mémoire magnéto-résistive (MRAM acronyme de Magnetoresistive Random Access Memory) à transfert de spin-orbite (SOT acronyme de Spin-Orbit-Torque) est une mémoire non volatile avancée qui utilise des mécanismes magnétiques pour stocker des données. Elle repose sur des jonctions tunnel magnétiques dont la résistance varie en fonction de l'orientation des couches magnétiques. Contrairement à la MRAM classique, la MRAM SOT utilise le transfert de spin-orbite, où des courants à travers une piste formée par des matériaux à fort couplage spin-orbite induisent la commutation de l'état magnétique dans une structure jonction tunnel en contact avec ladite piste. Cela permet des commutations plus rapides, une meilleure endurance et une efficacité énergétique accrue. La technologie MRAM SOT est idéale pour des applications nécessitant une mémoire rapide, non volatile et durable. Cette durabilité est obtenue grâce au fait que l'écriture ne nécessite pas un passage du courant d'écriture dans le pilier jonction tunnel magnétique.

Cependant, la cellule mémoire d'une MRAM SOT est différente des mémoires non volatiles standards telles que PCRAM, CBRAM, FeRAM et MRAM STT, qui sont des dispositifs électroniques à deux ports composés d'un élément résistif (1R) et d'un transistor (1T) avec des chemins d'écriture et de lecture confondus (notée 1T1R). La cellule mémoire d'une MRAM SOT est un dispositif électronique à trois ports comprenant un élément magnéto-résistif (1R), une piste d'écriture (SOT) et deux transistors (2T) avec des chemins d'écriture et de lecture séparés. Cette configuration, notée 2T1R, entraîne une densité d'intégration plus faible pour la MRAM SOT, qui est par nature moins compacte. Cette configuration de la cellule mémoire MRAM-SOT la rend incompatible avec un agencement matriciel en croix, (ou crossbar en anglais) à cause de l'utilisation des deux transistors.

Pour les mémoires non volatiles standards telles que PCRAM, CBRAM, FeRAM, les mémoires en croix (crossbar) ont été développées, connectant les points mémoires par deux lignes métalliques perpendiculaires pour augmenter la densité de la structure. L'écriture et la lecture se font par des tensions spécifiques, avec des courants suivant les lois de Kirchhoff. La sélection des points mémoires utilise des sélecteurs (S) au lieu de transistors, rendant les cellules mémoires 1S1R beaucoup plus compactes. Les sélecteurs sont des nano-interrupteurs volatiles Off/On commandés en tension. Les sélecteurs généralement utilisés pour les cellules mémoires 1S1R sont les varistances formées par les conducteurs à filament principalement en ZrO₂ ou HfO₂ ou par les conducteurs à changement de phases OTS (acronyme de Ovionic Threshold Switches). Ces types de sélecteurs ne sont pas compatibles avec des cellules mémoires MRAM et plus spécifiquement MRAM-SOT qui ont des plages de fonctionnement en tension réduites. D'une part, la plage de tension d'une cellule mémoire MRAM est limitée à cause de la faible tension de claquage de la barrière tunnel (de 1.3V à 2V) ; d'autre part, les sélecteurs précités présentent une tension de seuil de basculement ON/OFF de l'ordre de 5V.

Il existe en outre un besoin pour concevoir au moins une implémentation matricielle de la nouvelle architecture de cellule mémoire MRAM-SOT et pour définir au moins une programmation en lecture/écriture adaptée permettant de mettre en œuvre la nouvelle cellule mémoire selon l'invention dans un cadre applicatif.

Le même besoin existe avec le concept de mémoire MRAM-OTT (Orbital Transfert Torque) qui utilise l'injection de courants de moments orbitaux à la place de courants de spins en remplaçant la piste d'écriture SOT en tungstène par une piste OTT par exemple en titane. L'invention est décrite pour les cellules mémoire MRAM-SOT avec une piste d'écriture en un matériau à effet de couple spin-orbite mais reste valable aussi pour les mémoires MRAM-OTT (Orbital Transfert Torque). Les avantages et les caractéristiques exposés pour les cellules mémoire MRAM-SOT restent valables pour les mémoires MRAM-OTT.

### Art antérieur/ Restrictions de l'état de l'art

La publication scientifique [1] décrit une solution qui consiste à remplacer, dans une cellule mémoire MRAM-SOT, le transistor de lecture lorsqu'il est en série avec le pilier jonction tunnel magnétique par une diode. Il s'agit d'une structure de type 1S1T1R. Cette solution présente un inconvénient relatif à la densité car les diodes restent trop grandes par rapport à la cellule mémoire. De plus, la diode augmente significativement l'énergie de lecture à cause de la chute de tension dans la diode qui est plus grande.

Le brevet américain US11289143B2 présente une cellule mémoire MRAM-SOT dans laquelle le transistor d'écriture connecté en série avec la piste SOT est remplacé par un sélecteur mais conservant le transistor de lecture en série avec le pilier jonction tunnel magnétique. Il s'agit d'une structure de type 1S1T1R. Dans la cellule mémoire proposée, une opération d'écriture nécessite le passage du courant d'écriture à travers la moitié de la piste SOT et à travers la jonction tunnel magnétique ce qui induit deux inconvénients majeurs : une diminution de la durabilité de la cellule mémoire car le courant passe par la jonction tunnel magnétique ce qui réduit sa robustesse, et une réduction de l'efficacité d'écriture (par effet SOT) car le courant d'écriture traverse uniquement la moitié de la piste SOT.

### Réponse au problème et apport de solution

Pour pallier les limitations des solutions existantes, l'invention propose une cellule mémoire magnéto-résistive à couple spin-orbite ayant une structure 2S1R permettant de réaliser des structures mémoire denses Les cellules mémoires comprennent des sélecteurs (appelés aussi nano-interrupteurs) intégrés basés sur une couche en un matériau ayant une transition métal-isolant configurable, de préférence en oxydes de Mott compatibles avec des basses tensions. Une alternative est possible avec des sélecteurs intégrés basés sur des matériaux 2D de type isolant topologique.

De plus, l'invention présente des modes d'écriture asynchrones exploitant l'effet d'hystérésis dans les matériaux formant les sélecteurs et permettant la minimisation du nombre de tensions de commandes nécessaires pour réaliser une écriture. Cela permet de réduire considérablement la consommation énergétique des cellules mémoires. L'invention propose en outre plusieurs modes de lecture compatibles avec la cellule mémoire selon l'invention.

De plus, l'invention présente une pluralité d'architectures de matrices mémoires basées sur la nouvelle cellule mémoire et permettant de mettre en œuvre les différents modes d'écriture et de lecture proposés par l'invention.

### Résumé /Revendications

L'invention a pour objet une cellule mémoire magnéto-résistive comprenant :
- un pilier formant une jonction tunnel magnétique et ayant une extrémité supérieure destinée à recevoir une première tension de commande et une extrémité inférieure ;
- une piste d'écriture en un matériau à effet Hall de spin ou un matériau à effet Hall orbital ; le pilier étant disposé sur ladite piste d'écriture du côté de son extrémité inférieure ;
- une couche support en un matériau présentant une transition métal-isolant configurable ; la couche support ayant une première face et une seconde face opposée ; la piste d'écriture étant disposée sur ladite première face ;
- une première électrode disposée sur ladite seconde face et destinée à recevoir une seconde tension de commande ; la partie de la couche support confinée entre la première électrode et la piste d'écriture présentant un état de conduction configurable par la première et la seconde tension de commande de manière à former un premier sélecteur ayant un état résistif haut et un état résistif bas ;
- une seconde électrode disposée sur ladite seconde face et destinée à recevoir une troisième tension de commande ; la partie de la couche support confinée entre la seconde électrode et la piste d'écriture présentant un état de conduction configurable par la première et la troisième tension de commande de manière à former un second sélecteur ayant un état résistif haut et un état résistif bas.

Selon un aspect particulier de l'invention, la couche support est en oxyde de Mott ou un isolant topologique.

Selon un aspect particulier de l'invention, la piste d'écriture est en contact physique avec ladite première face de la couche support.

Selon un aspect particulier de l'invention, la couche support présente une largeur supérieure ou égale à celle de la piste d'écriture.

Selon un aspect particulier de l'invention, la piste d'écriture est réalisée en un matériau à effet Hall de spin choisi parmi du tungstène en phase béta ou de l'antimoniure de bismuth ou un alliage BiSbTe.

Selon un aspect particulier de l'invention, la piste d'écriture est réalisée en un matériau à effet Hall orbital choisi parmi en chrome ou le zirconium ou le titane ou le vanadium ou le cuivre ou le manganèse ou le molybdène ou le ruthénium ou l'aluminium ou le niobium ou le tungstène en phase alpha.

Selon un aspect particulier de l'invention, la piste d'écriture présente une épaisseur inférieure ou égale à 20 nm, avantageusement 10nm et plus avantageusement 5nm.

Selon un aspect particulier de l'invention, le premier et/ou le second sélecteur présente une résistance supérieure ou égale à 10 fois la résistance de la piste d'écriture lorsque ledit sélecteur est à un état résistif haut.

Selon un aspect particulier de l'invention, le premier et/ou le second sélecteur présente une résistance supérieure ou égale à 10 fois la résistance de la jonction tunnel magnétique lorsque ledit sélecteur est à un état résistif haut.

Selon un aspect particulier de l'invention, le premier et/ou le second sélecteur présente une résistance inférieure ou égale à la résistance de la piste d'écriture lorsque ledit sélecteur est à un état résistif bas.

Selon un aspect particulier de l'invention, le premier et/ou le second sélecteur présente une résistance inférieure ou égale à un dixième de la résistance de la jonction tunnel magnétique lorsque ledit sélecteur est à un état résistif bas.

Selon un aspect particulier de l'invention, la cellule mémoire magnéto-résistive comprend en outre un transistor de commande ; la source dudit transistor de commande étant connectée à l'extrémité supérieure du pilier.

Selon un aspect particulier de l'invention, la cellule mémoire magnéto-résistive comprend en outre un transistor d'atténuation ; le drain dudit transistor d'atténuation étant connecté à la première électrode.

Selon un aspect particulier de l'invention, le premier et/ou le second sélecteur est adapté pour passer d'un état résistif haut à un état résistif bas lorsque l'amplitude de la tension aux bornes dudit sélecteur est supérieure à une tension de seuil prédéterminée.

L'invention a pour objet également un circuit mémoire comprenant :
- une matrice mémoire formée par une pluralité de cellules mémoire selon l'invention ;
- un circuit de contrôle configuré pour générer la première tension de commande, la seconde tension de commande et la troisième tension de commande.

Selon un aspect particulier de l'invention, le circuit de contrôle est configuré pour réaliser une opération d'écriture sur une cellule mémoire de la matrice en lui appliquant :
- une première tension de commande nulle, une seconde tension de commande supérieure à la tension de seuil prédéterminée et une troisième tension de commande nulle pour écrire un premier état logique ;
- une première tension de commande nulle, une seconde tension de commande nulle et une troisième tension de commande supérieure à la tension de seuil prédéterminée pour écrire un second état logique complémentaire au premier état logique.

Selon un aspect particulier de l'invention, le circuit de contrôle est configuré pour réaliser une opération d'écriture sur une cellule mémoire de la matrice en lui appliquant :
- une première tension de commande supérieure à la tension de seuil prédéterminée , une seconde tension de commande égale à la première tension de commande et une troisième tension de commande nulle pour écrire un premier état logique ;
- une première tension de commande supérieure à la tension de seuil prédéterminée , une seconde tension de commande nulle et une troisième tension de commande égale à la première tension de commande pour écrire un second état logique complémentaire au premier état logique.

Selon un aspect particulier de l'invention, le circuit de contrôle est configuré pour réaliser une opération d'écriture sur une cellule mémoire de la matrice en lui appliquant :
- une seconde tension de commande supérieure au double de la tension de seuil prédéterminée ; une première tension de commande égale à la moitié de la seconde tension de commande et une troisième tension de commande nulle pour écrire un premier état logique ;
- une troisième tension de commande supérieure au double de la tension de seuil prédéterminée ; une première tension de commande égale à la moitié de la troisième tension de commande et une seconde tension de commande nulle pour écrire un second état logique complémentaire au premier état logique.

Selon un aspect particulier de l'invention, le circuit de contrôle est configuré pour réaliser une opération de lecture d'une cellule mémoire de la matrice mémoire en lui appliquant une seconde et une troisième tension de commande supérieures à la tension de seuil prédéterminée et une première tension de commande nulle.

Selon un aspect particulier de l'invention:
- les extrémités supérieures des piliers des cellules mémoires appartenant à la même colonne de la matrice mémoire sont interconnectées via une première ligne conductrice destinée à propager la première tension de commande associée ;
- les premières électrodes des cellules mémoires appartenant à la même ligne de la matrice mémoire sont interconnectées via une seconde ligne conductrice destinée à propager la seconde tension de commande associée ;
- les secondes électrodes des cellules mémoires appartenant à la même ligne de la matrice mémoire sont interconnectées via une troisième ligne conductrice destinée à propager la troisième tension de commande associée.

Selon un aspect particulier de l'invention :
- les extrémités supérieures des piliers des cellules mémoires appartenant à la même colonne de la matrice mémoire sont interconnectées via une première ligne conductrice destinée à propager la première tension de commande associée ;
- les premières électrodes des cellules mémoires appartenant à la même ligne de la matrice mémoire sont interconnectées via une seconde ligne conductrice destinée à propager la seconde tension de commande associée ;
- les secondes électrodes des cellules mémoires appartenant à la même colonne de la matrice mémoire sont interconnectées via une troisième ligne conductrice destinée à propager la troisième tension de commande associée ;

Selon un aspect particulier de l'invention :
- les grilles des transistors de commande des cellules mémoires appartenant à la même colonne de la matrice mémoire sont interconnectées via une première ligne conductrice destinée à propager un signal de sélection associée ;
- les drains des transistors de commande des cellules mémoires appartenant à la même ligne de la matrice mémoire sont interconnectés via une seconde ligne conductrice destinée à propager la première tension de commande associée ;
- les premières électrodes des cellules mémoires appartenant à la même ligne de la matrice mémoire sont interconnectées via une troisième ligne conductrice destinée à propager la seconde tension de commande associée ;
- les secondes électrodes des cellules mémoires appartenant à la même colonne de la matrice mémoire sont interconnectées via une quatrième ligne conductrice destinée à propager la troisième tension de commande associée ;

Selon un aspect particulier de l'invention :
- les extrémités supérieures des piliers des cellules mémoire appartenant à la même ligne de la matrice mémoire sont interconnectées via une première ligne conductrice destinée à propager la première tension de commande associée ;
- les sources des transistors d'atténuation des cellules mémoire appartenant à la même ligne de la matrice mémoire sont interconnectées via une seconde ligne conductrice destinée à propager la seconde tension de commande associée ;
- les secondes électrodes des cellules mémoire appartenant à la même colonne de la matrice mémoire sont interconnectées via une troisième ligne conductrice destinée à propager la troisième tension de commande associée ;
- les grilles des transistors d'atténuation des cellules mémoire appartenant à la même colonne de la matrice mémoire sont interconnectées via une quatrième ligne conductrice destinée à propager un signal de sélection associé ;

Selon un aspect particulier de l'invention :
- les extrémités supérieures des piliers des cellules mémoire appartenant à la même colonne de la matrice mémoire sont interconnectées via une première ligne conductrice destinée à propager la première tension de commande associée ;
- les sources des transistors d'atténuation des cellules mémoires appartenant à la même ligne de la matrice mémoire sont interconnectées via une seconde ligne conductrice destinée à propager la seconde tension de commande associée ;
- les secondes électrodes des cellules mémoires appartenant à la même ligne de la matrice mémoire sont interconnectées via une troisième ligne conductrice destinée à propager la troisième tension de commande associée ;
- les grilles des transistors de commande des cellules mémoires appartenant à la même colonne de la matrice mémoire sont interconnectées via une quatrième ligne conductrice destinée à propager un signal de sélection associé.

### Description détaillée

D'autres caractéristiques et avantages de la présente invention apparaîtront mieux à la lecture de la description qui suit en relation aux dessins annexés suivants.
La figure 1a illustre une vue en coupe d'une cellule mémoire magnéto-résistive à couple spin-orbite, selon l'invention, selon une première configuration.
La figure 1b illustre une vue en coupe d'une cellule mémoire magnéto-résistive à couple spin-orbite, selon l'invention, selon une seconde configuration.
La figure 1c illustre un schéma électrique d'une cellule mémoire magnéto-résistive à couple spin-orbite, selon l'invention.
La figure 2 illustre un schéma fonctionnel d'un circuit mémoire selon l'invention.
La figure 3a illustre les étapes d'un premier mode d'écriture de la cellule mémoire selon l'invention.
La figure 3b illustre les étapes d'un deuxième mode d'écriture de la cellule mémoire selon l'invention.
La figure 3c illustre les étapes d'un troisième mode d'écriture de la cellule mémoire selon l'invention.
La figure 3d illustre les étapes d'un premier mode de lecture de la cellule mémoire selon l'invention.
La figure 3e illustre les étapes d'un deuxième mode de lecture de la cellule mémoire selon l'invention.
La figure 4a illustre un schéma électrique d'une matrice mémoire utilisée dans le circuit mémoire selon un premier mode de réalisation de l'invention.
La figure 4b illustre un schéma électrique d'une matrice mémoire utilisée dans le circuit mémoire selon un deuxième mode de réalisation de l'invention.
La figure 4c illustre un schéma électrique d'une matrice mémoire utilisée dans le circuit mémoire selon un troisième mode de réalisation de l'invention.
La figure 4d illustre un schéma électrique d'une matrice mémoire utilisée dans le circuit mémoire selon un quatrième mode de réalisation de l'invention.
La figure 4e illustre un schéma électrique d'une matrice mémoire utilisée dans le circuit mémoire selon un cinquième mode de réalisation de l'invention.

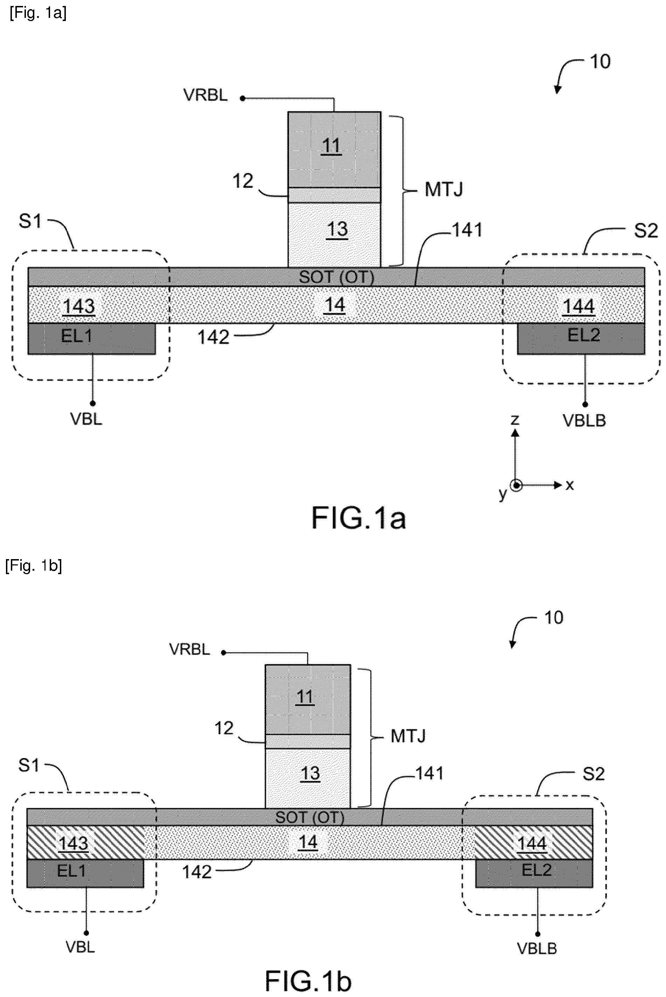

La figure 1a illustre une vue en coupe d'une cellule mémoire 10 magnéto-résistive à couple spin-orbite, selon l'invention. La cellule mémoire 10 comprend une jonction tunnel magnétique MTJ , une piste d'écriture SOT, une couche support 14, une première électrode EL1 et une seconde *électrode* EL2.

La jonction tunnel magnétique MTJ est un pilier magnéto résistif comprenant un empilement de couches 11,12,13 qui travaillent ensemble pour permettre le stockage et la lecture des données via la manipulation des propriétés magnétiques. L'empilement comprend une première couche 11 ferromagnétique de référence dans laquelle la direction de la polarisation magnétique est fixe et uniforme. L'empilement comprend en outre une seconde couche 13 ferromagnétique dans laquelle la direction de la polarisation magnétique est variable. L'empilement comprend en outre une couche barrière tunnel 12 d'oxyde, telle que MgO (oxyde de magnésium), confinée entre la première et la seconde couche ferromagnétique 11,13. Cette couche joue un rôle crucial dans l'effet tunnel magnétorésistif, permettant aux électrons de traverser par effet tunnel quantique. La couche barrière tunnel 12 présente une épaisseur inférieure à 1nm. La première couche ferromagnétique 11 sert de référence pour détecter les changements de magnétisation dans la couche ferromagnétique libre 13. Par exemple, la première et la seconde couche 11,13 sont composées de matériaux comme le CoFeB. Le principe de fonctionnement du pilier MTJ magnétorésistif repose sur le changement de la résistance électrique en fonction de l'orientation de polarisation magnétique de la couche ferromagnétique libre 13 par rapport à celle dans la couche ferromagnétique de référence 11 référence. Lorsque les aimantations des couches libres et de référence 11,13 sont parallèles, la résistance électrique est faible à travers le pilier de jonction tunnel magnétique MTJ. Lorsque les aimantations sont antiparallèles, la résistance électrique est élevée. Ce changement de résistance est détecté pour lire un état de la mémoire (bit 0 ou 1). Ce changement de résistance est provoqué pour écrire un état de la mémoire (bit 0 ou 1).

La jonction tunnel magnétique MTJ repose sur la piste d'écriture SOT. L'interface entre la jonction tunnel magnétique MTJ et la piste d'écriture SOT est du côté de la couche ferromagnétique libre 13. La direction de l'empilement formant la jonction tunnel magnétique MTJ est orthogonale au plan formé par la couche formant la piste d'écriture SOT. La piste d'écriture SOT est réalisée en un matériau à effet hall de spin (dénommé aussi matériau à effet de couple spin-orbite ), par exemple le tungstène en phase béta ou l'antimoniure de bismuth ou un empilement de deux couches l'une en tantale et l'autre en tungstène ou un alliage BiSbTe. Lorsqu'un courant d'écriture traverse la piste d'écriture SOT selon une direction, des courants de spin sont générés et interagissent avec la couche ferromagnétique libre 13. Cette interaction permet un contrôle de la direction de polarisation magnétique dans la couche ferromagnétique libre 13 selon la direction du courant d'écriture dans la piste d'écriture SOT. Le contrôle de la direction de polarisation magnétique dans la couche ferromagnétique libre 13 permet de modifier la résistance électrique de la jonction tunnel magnétique MTJ sans y injecter un courant d'écriture, ce qui augmente considérablement la robustesse de la cellule mémoire 10.

La piste d'écriture SOT est disposée sur une première face 141 de la couche support 14. La couche support 14 est réalisée en un matériau ayant une transition métal-isolant, plus particulièrement un oxyde de Mott. Ce type de matériau présente une possibilité de transition résistive volatile entre un état résistif haut et un état résistif bas. Cette transition est activée thermiquement et/ou électriquement et/ou optiquement. Elle consiste en un changement de phase non permanent (volatile) entre une phase ortho-clinique semi-conductrice stable à haute résistance et une phase tétragonale rutile conductrice métastable à faible résistance. L'état résistif bas ne se maintient que sous stimulation thermique, électrique ou optique. L'invention exploite la stimulation électrique par application d'un champ électrique. L'épaisseur de la couche support 14 est comprise entre 5 nm et 100 nm.

La première électrode EL1 est disposée sur une seconde face 142 de la couche support 14 opposée à la première face 141. La première électrode EL1 est positionnée en dessous d'une première extrémité de la piste d'écriture SOT. La seconde électrode EL2 est disposée sur la seconde face 142. La seconde électrode EL2 est positionnée en dessous d'une seconde extrémité de la piste d'écriture SOT opposée à la première extrémité. Le pilier formant la jonction tunnel magnétique MTJ se situe entre la première extrémité et la seconde extrémité. La première électrode EL1 et la seconde électrode EL2 sont chacune réalisées par une couche électriquement conductrice en métal par exemple, de préférence en tungstène ou en cuivre ou en nitrure de titane.

D'un point de vue électrique, une première tension de commande VRBL est appliquée sur l'extrémité supérieure du pilier formant la jonction tunnel magnétique MTJ. Une seconde tension de commande VBL est appliquée sur la première électrode EL1. Une troisième tension de commande VBLB est appliquée sur la seconde électrode EL2.

L'empilement formé par la première électrode EL1, la zone 143 de la couche support 14 en un matériau avec une transition métal-isolant et la piste d'écriture SOT forme localement un sélecteur S1 de dimensions réduites. Le sélecteur S1 est configurable entre un état résistif haut R1_{OFF} et un état résistif bas R1_{ON} via l'application d'une tension entre la première électrode EL1 et la piste d'écriture SOT c'est-à-dire la première et la seconde tension VRBL, VBL. De même, l'empilement formé par la seconde électrode EL2, la zone 144 de la couche support 14 en un matériau avec une transition métal-isolant et la piste d'écriture SOT forme localement un second sélecteur S2 de dimensions réduites. Le second sélecteur S2 est configurable entre un état résistif haut R2_{OFF} et un état résistif bas R2_{ON} via l'application d'une tension entre la seconde électrode EL2 et la piste d'écriture SOT c'est-à-dire la première et la troisième tension VRBL, VBLB. Pour chaque sélecteur parmi S1 et S2, l'activation (passage de R_{OFF} à R_{ON}) se déclenche lorsque l'amplitude de la tension aux bornes du sélecteur dépasse une tension de seuil prédéterminée Vth. Par exemple, pour une couche support 14 en oxyde de vanadium la tension de seuil est égale à 0.6V ce qui est compatible avec les plages de fonctionnement en tension d'une cellule mémoire magnéto résistive.

Alternativement, la couche support 14 comprend un isolant topologique à basse tension (< 1 V), par exemple le disulfure de molybdène. Un isolant topologique est un matériau qui a la propriété intéressante de se comporter comme un isolant à l'intérieur (il ne conduit pas l'électricité à travers son volume), tout en ayant des surfaces ou des bords conducteurs. Ce type de matériau est dit "topologique" parce que ses propriétés conductrices de surface sont protégées par des caractéristiques topologiques de la structure électronique du matériau, ce qui signifie qu'elles sont robustes face aux perturbations comme les impuretés ou les défauts structurels.

Les sélecteurs S1, S2 peuvent être activés simultanément au moyen d'une même tension de commande (même amplitude et même signe) ou indépendamment au moyen de deux tensions de commande distinctes (même amplitude et signes opposés). On peut donc gérer selon le signe de la tension appliquée le sens passant des sélecteurs soit vers le haut (de l'électrode associée vers la piste d'écriture SOT) soit vers le bas (de la piste d'écriture SOT vers l'électrode). Ainsi un courant bipolaire pourra ainsi circuler à travers l'intégralité de la piste SOT pour l'écriture avec des commandes de signes opposés et un courant unipolaire pourra traverser le pilier MTJ après avoir parcouru la moitié de la piste SOT pour la lecture avec des commandes de mêmes signes.

La piste d'écriture SOT est en contact physique avec ladite première face 141 de la couche support 14. La couche support 14 présente une largeur supérieure ou égale à celle de la piste d'écriture SOT, selon la direction X. Cela permet d'avoir une interface de contact entre la couche support 14 et toute la face inférieure de la piste d'écriture SOT. Ainsi, la couche support 14 est partagée entre les deux sélecteurs S1, S2. La zone centrale de la couche support 14 qui ne correspond ni à la zone 143 ni à la zone 144 est toujours à l'état isolant ce qui permet d'isoler électriquement le premier sélecteur S1 du second sélecteur S2 et inversement. Cet agencement permet de faciliter le procédé de fabrication de la cellule mémoire puisqu'il est possible de maximiser la phase β dans la piste d'écriture SOT sur toute la largeur de la cellule mémoire avec une seule opération de croissance de la piste d'écriture SOT.

La figure 1a illustre une vue en coupe de la cellule mémoire magnéto-résistive à couple spin-orbite 10, selon une première configuration dans laquelle S1 et S2 sont chacun à un état résistif haut (bloquant). La figure 1b illustre une vue en coupe de la cellule mémoire magnéto-résistive à couple spin-orbite 10, selon une seconde configuration dans laquelle S1 et S2 sont chacun à un état résistif bas (passant).

L'utilisation des oxydes de Mott, de préférence l'oxyde de vanadium et l'oxyde de niobium, présente plusieurs avantages supplémentaires dans le contexte de l'invention.

D'abord, une particularité des oxydes de Mott est le maintien possible de l'état métallique une fois la transition réalisée, même lorsque la tension de commande redescend en dessous de la tension de seuil Vth à la condition qu'une circulation résiduelle de courant soit possible. Ce courant résiduel maintient une certaine température dans le cristal nécessaire à la stabilité de la phase rutile. Lorsque ce courant devient trop faible, en d'autres termes lorsque le cristal se refroidit suffisamment, la phase tétragonale prend le dessus et toute conduction électrique cesse. Cette particularité sera exploitée dans le cadre de cette invention pour réaliser une opération d'écriture dite « asynchrone» dans une cellule mémoire 10 selon l'invention.

De plus, un autre avantage découle de l'utilisation des oxydes de Mott pour réaliser la couche support 14 correspondant à l'amélioration de l'effet de couplage spin-orbite dans la piste d'écriture SOT. En effet, l'obtention de la phase β dans la piste d'écriture nécessite un apport en oxygène dans la maille du tungstène. En l'absence de source d'oxygène, on obtient la phase courante α du tungstène ou un mélange des deux phases, ce qui annule ou limite l'effet de couplage spin-orbite dans la piste d'écriture SOT. Cette faible quantité d'oxygène peut être apportée par exemple par le contact avec la couche support 14 en oxyde de Mott.

On obtient ainsi un double avantage grâce aux oxydes de Mott :
- D'une part, la nature oxyde de la couche support 14 permet alors de maximiser la phase β dans la piste d'écriture SOT (voire éliminer la phase α totalement) de manière à améliorer le couplage spin-orbite ;
- d'autre part la nature transitoire métal-isolant volatile des oxydes de Mott permet de réaliser les deux sélecteurs S1, S2 jouant le rôle de nano-interrupteurs compacts pour améliorer la densité de la cellule mémoire.

Dans le mode de réalisation de la figure 1a, le sens de l'empilement est le suivant en partant du substrat selon l'axe Z : les électrodes EL1 ;EL2 puis la couche support 14 puis la piste d'écriture SOT puis le pilier MTJ. Alternativement, la cellule mémoire 10 peut être réalisée dans un sens inversé par rapport à la cellule illustrée sur la figure 1a en partant du substrat comme origine de l'axe Z. Le pilier est dirigé vers le bas. Le sens de l'empilement est le suivant en partant du substrat selon l'axe Z : le pilier MTJ dirigé vers le bas puis la piste d'écriture SOT puis la couche support 14 puis les électrodes EL1,EL2 à la surface supérieure. Le pilier MTJ dirigé vers le bas est encapsulé dans une couche diélectrique.

Alternativement, la cellule mémoire 10 selon l'invention est une cellule mémoire magnéto-résistive exploitant l'effet Hall Orbital. Ce mode de réalisation diffère du mode de réalisation de la figure 1a en ce que la piste d'écriture est configurée pour générer un courant de moments orbitaux à partir d'un courant de charges et non un courant de spins. L'avantage d'un chemin d'écriture séparé du chemin de lecture est gardé. L'écriture se fait par conversion du courant de charges en un courant de moments orbitaux qui a une aptitude similaire au courant de spins à exercer un couple sur l'aimantation d'une couche magnétique. Il s'agit de l'effet Hall orbital (dit « OHE » pour « Orbital Hall Effect » en anglais) qui diffère de l'effet Hall de spins. L'écriture par effet Hall orbital permet d'améliorer les caractéristiques des mémoires magnétiques. La structure d'un dispositif à effet Hall orbital est similaire à celle d'un dispositif spin-orbite à la différence que la piste d'écriture, dite également piste « OT » pour « Orbital Torque » en anglais, est une piste configurée pour générer un courant de moments orbitaux à partir d'un courant de charges. Les moments orbitaux ne permettent pas de réaliser directement un couple sur l'aimantation de la jonction du pilier MTJ. L'un des deux mécanismes suivants peut être requis. L'action des moments orbitaux sur l'aimantation peut être due à un entrelacement des moments orbitaux avec les moments de spins (dit « spin-orbital entanglement » en anglais) et/ou une partie du courant de moments orbitaux est converti en courant de spins la jonction du pilier MTJ, ces derniers appliquant un couple sur une aimantation de la jonction du pilier MTJ. Dans le cas d'une cellule mémoire à effet Hall orbital, la piste d'écriture OT est réalisée en chrome ou en zirconium ou en titane ou en vanadium ou en cuivre ou en manganèse ou en molybdène ou en ruthénium ou en aluminium ou en niobium ou en tungstène en phase alpha.

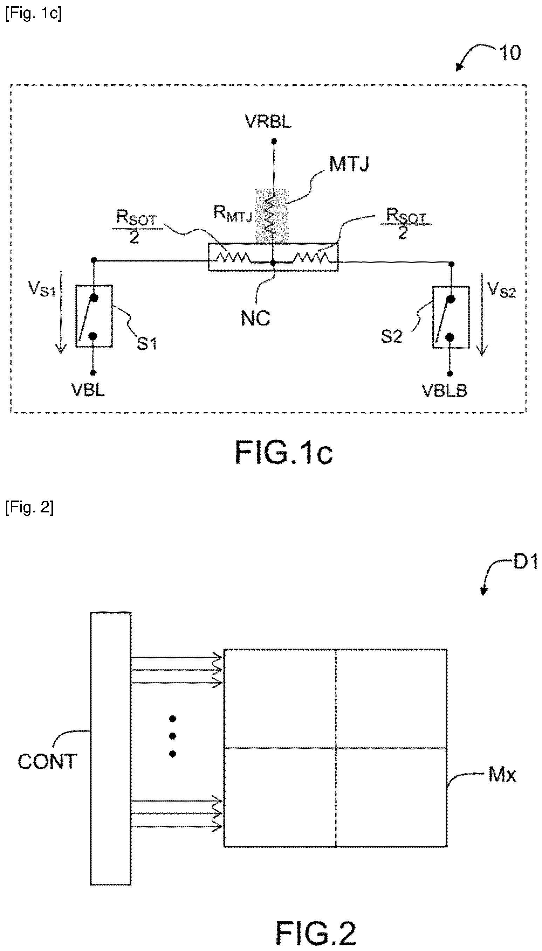

La figure 1c illustre un schéma électrique de la cellule mémoire magnéto-résistive à couple spin-orbite, 10 selon l'invention. Le premier sélecteur S1 est modélisé par un interrupteur commandé par la différence de potentiel VS1. Lorsque le premier sélecteur S1 est à un état passant, il est assimilé à une résistance R1_{ON} et lorsqu'il est à un état bloquant à une résistance R1_{OFF}. Le second sélecteur S2 est modélisé par un interrupteur commandé par la différence de potentiel VS2. Lorsque le second sélecteur S2 est à un état passant il est assimilé à une résistance R2_{ON} et lorsqu'il est à un état bloquant à une résistance R2_{OFF}. La portion de la piste d'écriture SOT située entre le premier sélecteur S1 et la base du pilier MTJ est modélisée par une résistance R_{SOT}/2 avec R_{SOT} la résistance électrique équivalente de la piste d'écriture. De manière symétrique, la portion de la piste d'écriture SOT située entre le second sélecteur S2 et la base du pilier MTJ est modélisée par une résistance R_{SOT}/2. Les deux résistances R_{SOT}/2 sont montées en série, et leur nœud commun NC est un nœud central situé au niveau de la base du pilier MTJ. Le pilier MTJ est modélisé par une résistance variable R_{MTJ} selon la donnée binaire « 1 » ou « 0 » stockée dans la cellule mémoire MTJ. On suppose que R1_{OFF} = R2_{OFF}= R_{OFF} et que R1_{ON} = R2_{ON}= R_{ON}.

Le comportement électrique de chaque sélecteur S1, S2 est défini par les trois paramètres suivants : la résistance à l'état passant R_{ON}, la résistance à l'état bloquant R_{OFF} et la tension de seuil Vth. Ces trois paramètres peuvent être modulés en modifiant la composition de la couche support 14. Selon un aspect particulier de l'invention, au moins les zones 143 et 144 de la couche support 14 sont dopées avec des atomes de chrome, fer, aluminium ou titane pour baisser la valeur de la tension de seuil Vth et de la résistance à l'état passant R_{ON} et pour augmenter la résistance à l'état bloquant R_{OFF}. Selon un aspect particulier de l'invention, au moins les zones 143 et 144 de la couche support 14 sont dopées avec des atomes de titane ou tungstène pour augmenter la valeur de la tension de seuil Vth et de la résistance à l'état passant R_{ON} et pour baisser la résistance à l'état bloquant R_{OFF}.

Lors d'une opération d'écriture, un courant d'écriture i_{w} est injecté à travers la piste d'écriture SOT à partir de la première électrode EL1 vers la seconde électrode EL2 ou inversement. Le courant d'écriture i_{w} ne traverse pas le pilier MTJ et ne dépend pas de l'état résistif R_{MTJ} dudit pilier. Le courant d'écriture i_{w} dépend du ratio R_{ON}/R_{SOT}. Lors d'une opération de lecture, un courant de lecture iᵣ est injecté à travers la pilier MTJ à partir de la première électrode EL1 et/ou la seconde électrode EL2. Le courant de lecture iᵣ dépend du ratio R_{ON}/R_{MTJ}.

La composition et le dimensionnement d'au moins les parties 143, 144 de la couche support 14 sont choisis de manière à obtenir les inégalités suivantes :
- R_{ON} < R_{SOT} pour avoir un courant d'écriture i_{w} ayant une amplitude suffisante pour modifier la polarisation magnétique dans le pilier MTJ, plus avantageusement R_{ON} ≤ 0.1 x R_{SOT} ; une amplitude suffisante pour l'écriture est généralement supérieure à 100µA.
- R_{ON} < 0.1x R_{MTJ} pour avoir un courant de lecture iᵣ ayant une amplitude suffisante pour déterminer l'état résistif de la jonction magnéto-résistive MTJ ; une amplitude suffisante pour la lecture est généralement supérieure à 10µA.
- R_{OFF} ≥ 10 x R_{SOT} pour pouvoir faire commuter les sélectionneurs S1, S2 d'un état bloquant à un état passant lors d'une opération d'écriture, plus avantageusement R_{OFF} ≥ 50 x R_{SOT};
- R_{OFF} ≥ 10x R_{MTJ} pour pouvoir faire commuter les sélectionneurs S1, S2 d'un état bloquant à un état passant lors d'une opération de lecture, plus avantageusement R_{OFF} ≥ 100x R_{MTJ};

La figure 2 illustre un schéma fonctionnel d'un circuit mémoire D1 selon l'invention comprenant une matrice mémoire Mx formée par une pluralité de cellules mémoire 10 selon l'invention et un circuit de contrôle CONT configuré pour générer au moins la première tension de commande VRBL, la seconde tension de commande VBL et la troisième tension de commande VBLB selon le choix de l'arrangement de la matrice Mx.

La cellule mémoire 10 selon l'invention est compatible avec plusieurs modes d'écriture et de lecture qu'on détaillera dans la section suivante.

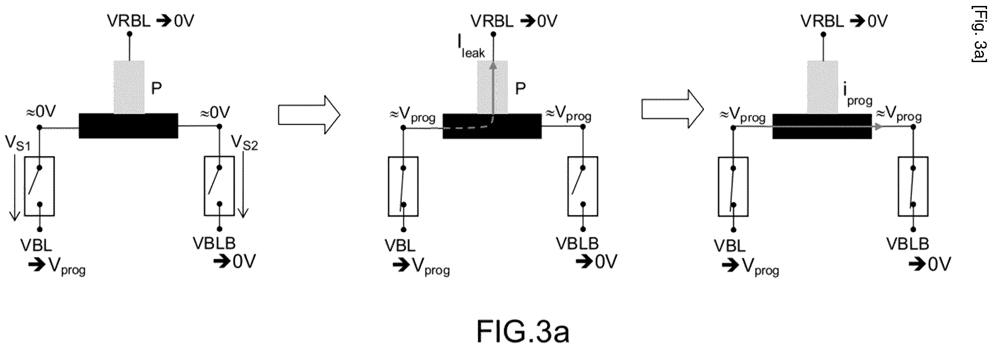

La figure 3a illustre les étapes d'un premier mode d'écriture de la cellule mémoire 10 selon l'invention. Initialement, les deux sélecteurs S1, S2 sont à l'état bloquant. Le circuit de contrôle CONT est configuré pour appliquer en même temps : une première tension de commande VRBL nulle sur l'extrémité supérieure du pilier MTJ , une seconde tension de commande VBL = V_{prog} telle que V_{prog} > Vth et une troisième tension de commande VBLB nulle. Le potentiel nul se propage à travers le pilier MTJ vers la piste d'écriture SOT. Le premier sélecteur voit ainsi à ses bornes une tension +V_{prog} supérieure à la tension de seuil et commute à un état passant connectant ainsi la piste d'écriture SOT à la première électrode EL1 qui fournit la tension d'écriture +V_{prog}. Pendant une période transitoire, un courant de fuite va parcourir le pilier MTJ. Le courant de fuite est par exemple inférieur à 80µA et donc ne modifie pas de manière accidentelle l'état résistif du pilier MTJ et ne dépasse pas le courant de claquage de la jonction tunnel magnétique. Pendant cette période transitoire, le potentiel +V_{prog} s'établit progressivement aussi sur l'autre extrémité de la piste d'écriture SOT située au niveau du second sélecteur S2 qui voit ainsi à ces bornes une tension -V_{prog} ayant une amplitude supérieure à la tension de seuil Vth. La fin du régime transitoire correspond à la commutation du second sélecteur S2 sous l'action de la tension - V_{prog} propagée par la piste d'écriture SOT pour laisser le courant d'écriture s'établir de la première électrode EL1 vers la seconde électrode EL2. L'avantage du premier mode d'écriture selon l'invention est qu'il est possible d'écrire dans la cellule mémoire 10 par l'application d'une seule tension d'écriture non-nulle +V_{prog} sur la première électrode EL1. Enfin, la seconde tension de commande VBL est remise progressivement à zéro pour mettre fin à l'opération. Il a été, ainsi, possible de faire passer un courant d'écriture de la première électrode EL1 vers la seconde électrode EL2 à travers la piste d'écriture SOT pour écrire un premier état logique « 0 » par exemple.

Pour écrire un état logique complémentaire « 1 », il suffit d'appliquer une première tension de commande VRBL nulle sur l'extrémité supérieure du pilier MTJ , une seconde tension de commande VBL nulle et une troisième tension de commande VBLB = V_{prog} telle que V_{prog} > Vth. De manière symétrique, on obtient par le même mécanisme décrit un courant d'écriture de la seconde électrode EL2 vers la première électrode EL1 à travers la piste d'écriture SOT pour écrire un second état logique « 1 ».

A titre d'exemple illustratif et non limitatif, si l'oxyde de Mott choisi est l'oxyde de vanadium, la tension de seuil est égale à 0.6V et la tension d'écriture V_{prog} = 0.7V pour obtenir un courant d'écriture supérieur à 100µA, avantageusement supérieur à 500µA.

Avantageusement, les deux sélecteurs S1, S2 restent à l'état passant pendant une durée supplémentaire grâce à une particularité des oxydes de Mott utilisés pour réaliser les deux sélecteurs S1, S2. En effet, durant la transition descendante, tant qu'une tension non nulle persiste aux bornes de S1, S2, elle assure le passage d'un courant ohmique résiduel par échauffement minimal. Le courant ohmique résiduel maintient suffisamment la stabilité thermique de la phase rutile conductrice dans les zones 143, 144. Lorsque la tension de commande VBL est ainsi ramenée à zéro, la transition descendante Métal/Isolant se trouve décalée très en dessous de la tension de seuil Vth. On parle ainsi, d'une opération d'écriture « asynchrone».

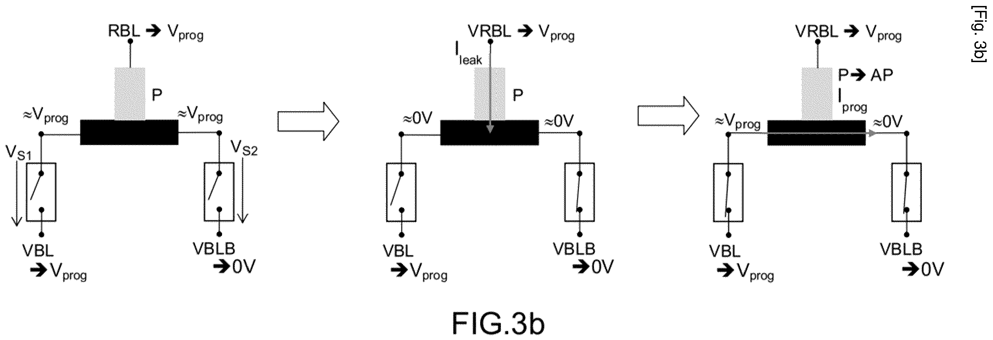

La figure 3b illustre les étapes d'un deuxième mode d'écriture de la cellule mémoire 10 selon l'invention. Le deuxième mode d'écriture selon l'invention est aussi une opération d'écriture « asynchrone». Initialement, les deux sélecteurs S1, S2 sont à l'état bloquant. Le circuit de contrôle CONT est configuré pour appliquer en même temps : une première tension de commande VRBL = V_{prog} telle que V_{prog} > Vth sur l'extrémité supérieure du pilier MTJ, une seconde tension de commande VBL = V_{prog} et une troisième tension de commande VBLB nulle. Le potentiel V_{prog} se propage à travers le pilier vers la piste d'écriture SOT. Le second sélecteur S2 voit ainsi à ses bornes une tension VS2 = VBLB - V_{SOT}= -V_{prog} supérieure à la tension de seuil et commute à un état passant connectant ainsi la piste d'écriture SOT à la second électrode EL2 connectée à la masse électrique GND. Pendant une période transitoire, un courant de fuite va parcourir le pilier MTJ pour être évacué par l'électrode EL2. Le courant de fuite est par exemple inférieur à 80µA et donc ne modifie pas de manière accidentelle l'état résistif du pilier MTJ et ne dépasse pas le courant de claquage de la jonction tunnel magnétique. Pendant cette période transitoire, la tension nulle (GND) s'établit progressivement aussi sur l'autre extrémité de la piste d'écriture SOT située au niveau du premier sélecteur S1 qui voit ainsi à ces bornes une tension +V_{prog} ayant une amplitude supérieure à la tension de seuil Vth. La fin du régime transitoire correspond à la commutation du premier sélecteur S1 sous l'action de la différence de potentiel VS1 = VBL - V_{SOT} = +V_{prog} - 0 pour laisser le courant d'écriture s'établir de la première électrode EL1 vers la seconde électrode EL2. Enfin, l'ensemble des tensions de commande VBL et VRBL sont remises progressivement à zéro pour mettre fin à l'opération d'écriture. Il a été, ainsi, possible de faire passer un courant d'écriture de la première électrode EL1 vers la seconde électrode EL2 à travers la piste d'écriture SOT pour écrire un premier état logique « 0 » par exemple.

Pour écrire un état logique complémentaire « 1 », il suffit d'appliquer une première tension de commande VRBL = V_{prog} telle que V_{prog} > Vth sur l'extrémité supérieure du pilier MTJ, une seconde tension de commande VBL nulle et une troisième tension de commande VBLB = V_{prog}. De manière symétrique, on obtient par le même mécanisme décrit un courant d'écriture de la seconde électrode EL2 vers la première électrode EL1 à travers la piste d'écriture SOT pour écrire un second état logique « 1 ».

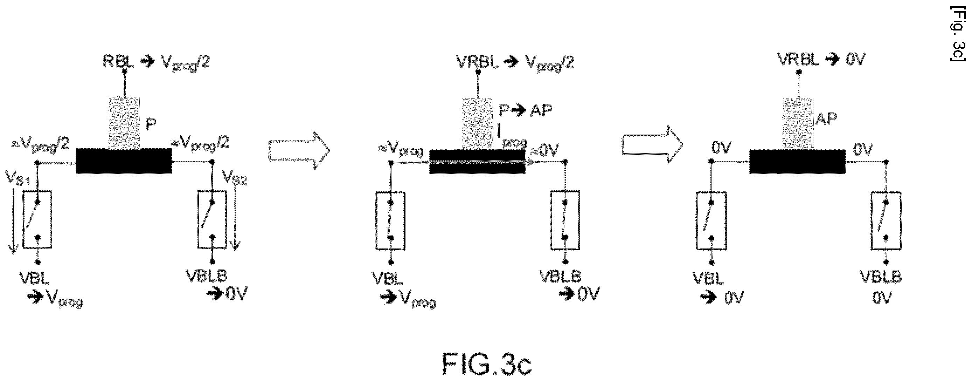

La figure 3c illustre les étapes d'un troisième mode d'écriture de la cellule mémoire 10 selon l'invention, de type « synchrone ». Ce mode est compatible avec une couche support 14 qui ne présente pas un effet d'hystérésis, comme par exemple dans le cas où ladite couche support 14 est dopée avec un élément additionnel (Cr, Al, Fe, W, Mo, Ta, Ru ...) ou réalisée par épitaxie. Ce mode d'écriture est également compatible avec une couche support 14 comprenant un isolant topologique, comme par exemple dans le MoS2.

Initialement, les deux sélecteurs S1, S2 sont à l'état bloquant. Le circuit de contrôle CONT est configuré pour appliquer en même temps : une première tension de commande VRBL = V_{prog} /2 telle que V_{prog} > 2x Vth sur l'extrémité supérieure du pilier MTJ , une seconde tension de commande VBL = V_{prog} et une troisième tension de commande VBLB = 0. Le potentiel V_{prog} /2 se propage à travers le pilier vers la piste d'écriture SOT. Le premier sélecteur S1 voit ainsi à ses bornes une tension VS1 = VBL - V_{SOT} = V_{prog} - V_{prog}/2 = +V_{prog}/2 supérieure à la tension de seuil et commute à un état passant connectant ainsi la piste d'écriture SOT à la première électrode EL1. Le second sélecteur S2 voit ainsi à ses bornes une tension VS2 = VBLB - V_{SOT} = 0 - V_{prog}/2 = -V_{prog}/2 ayant une amplitude supérieure à la tension de seuil et commute à un état passant connectant ainsi la piste d'écriture SOT à la seconde électrode EL2 connectée à la masse GND. Suite à l'activation simultanée des deux sélecteurs S1, S2, un courant d'écriture s'établit à travers la piste d'écriture SOT de la première électrode EL1 vers la seconde électrode EL2 pour écrire un premier état logique « 0 » par exemple. Enfin, l'ensemble des tensions de commande VBL, VBLB et VRBL sont remises progressivement à zéro et les sélecteurs passent à un état bloquant pour mettre fin à l'opération.

Pour écrire un état logique complémentaire « 1 » selon le troisième mode d'écriture, les moyens de contrôle CONT sont configurés pour appliquer en même temps : une première tension de commande VRBL = V_{prog}/2 telle que V_{prog} > 2x Vth sur l'extrémité supérieure du pilier MTJ , une seconde tension de commande VBL = 0 et une troisième tension de commande VBLB = V_{prog}. On obtient un courant d'écriture qui circule à travers la piste d'écriture SOT de la seconde électrode EL2 vers la première électrode EL1.

Le tableau 1 résume les différents modes d'écriture selon l'invention compatibles avec la cellule mémoire 10 :

| Mode d'écriture | État logique | condition | VRBL | VBL | VBLB |
|---|---|---|---|---|---|
| 1^{er} mode | 0 | V_{prog}>Vth | 0 | V_{prog} | 0 |
| 1^{er} mode | 1 | V_{prog}>Vth | 0 | 0 | V_{prog} |
| 2^{nd} mode | 0 | V_{prog}>Vth | V_{prog} | V_{prog} | 0 |
| 2^{nd} mode | 1 | V_{prog}>Vth | V_{prog} | 0 | V_{prog} |
| 3^{ème} mode | 0 | V_{prog}>2X Vth | ½ V_{prog} | V_{prog} | 0 |
| 3^{ème} mode | 1 | V_{prog}>2X Vth | ½ V_{prog} | 0 | V_{prog} |

Le premier et le deuxième mode d'écriture sont des modes asynchrones (activation différée des sélecteurs S1, S2), tandis que le troisième mode est synchrone (activation simultanée des sélecteurs S1, S2). Chaque mode d'écriture présente des avantages particuliers.

Les modes « asynchrones » sont avantageux parce qu'ils permettent de minimiser la tension d'écriture en fixant V_{prog} seulement 20 % plus grande que la tension de seuil de commutation des sélecteurs S1, S2. La cellule mémoire fournit un courant d'écriture suffisant, supérieur à 500 µA par exemple et avec très peu de courant de fuite dans le pilier MTJ. Les modes asynchrone et synchrone génèrent tous les deux des niveaux de courants d'écriture suffisants. En terme énergétique, les modes asynchrones en écriture sont les plus avantageux car ils permettent de réduire la consommation électrique en écriture par deux et de rester avec des tensions de commandes inférieures à 1 V. D'un autre côté, le troisième mode d'écriture synchrone permet de minimiser les courants de fuites à travers le pilier MTJ grâce à l'activation simultanée des sélecteurs S1, S2.

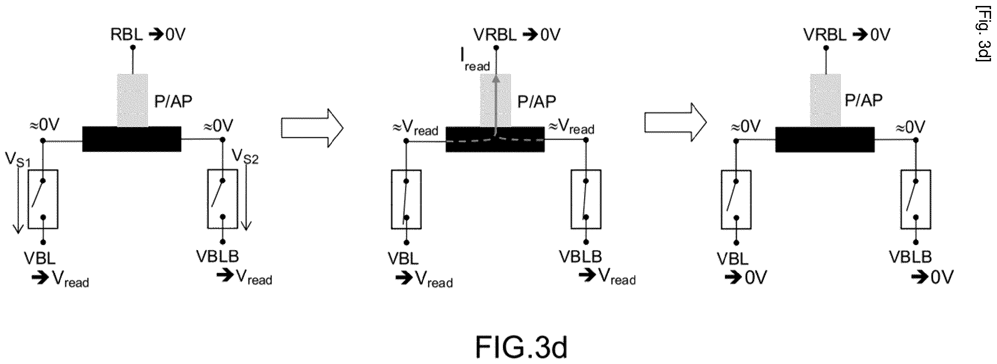

La figure 3d illustre les étapes d'un premier mode de lecture de la cellule mémoire 10 selon l'invention. Le circuit de contrôle CONT est configuré pour appliquer en même temps : une seconde tension de commande VBL = V_{read} telle que V_{read} > Vth, une troisième tension de commande VBLB = V_{read} et une première tension de commande VRBL nulle sur l'extrémité supérieure du pilier MTJ. Les deux sélecteurs S1, S2 commutent simultanément à un état passant et le potentiel V_{read} se propage à la piste d'écriture SOT sur laquelle repose le pilier MTJ. Le pilier MTJ voit ainsi à ses bornes une différence de potentiel presque égale à V_{read}. Dès lors, un courant de lecture peut s'établir avc une intensité qui dépend de l'état résistif du pilier MTJ. Le courant de lecture est la somme de deux courants : un premier courant injecté à partir de la première électrode EL1, et un second courant à partir de la seconde électrode EL2. Enfin, l'ensemble des tensions de commande VBL, VBLB et VRBL sont remises progressivement à zéro et les sélecteurs passent à un état bloquant pour mettre fin à l'opération de lecture. L'avantage de ce mode de lecture consiste au fait que lors de la lecture, deux courants opposés parcourent la piste d'écriture SOT ce qui élimine la possibilité d'écriture accidentelle.

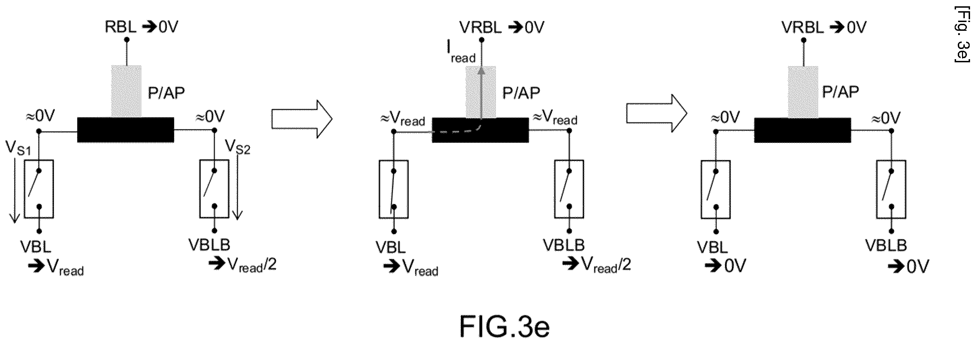

La figure 3e illustre les étapes d'un deuxième mode de lecture de la cellule mémoire 10 selon l'invention. Le circuit de contrôle CONT est configuré pour appliquer en même temps : une seconde tension de commande VBL = V_{read} telle que Vth < V_{read} <2xVth, une troisième tension de commande VBLB = ½ V_{read} et une première tension de commande VRBL nulle sur l'extrémité supérieure du pilier MTJ. Le premier sélecteur S1 commute à un état passant tandis que le second sélecteur reste à un état bloquant. Le potentiel V_{read} se propage à la piste d'écriture SOT sur laquelle repose le pilier MTJ. Le pilier voit ainsi à ses bornes une différence de potentiel presque égale à V_{read}. Dès lors, un courant de lecture peut s'établir avec une intensité qui dépend de l'état résistif du pilier MTJ. Le courant de lecture est injecté uniquement de la première électrode EL1. Enfin, l'ensemble des tensions de commande VBL, VBLB et VRBL sont remises progressivement à zéro et les sélecteurs passent à un état bloquant pour mettre fin à l'opération de lecture.

D'autres modes de lectures sont compatibles avec la cellule mémoire 10 selon l'invention. Le tableau 2 résume les différents modes de lecture selon l'invention compatibles avec la cellule mémoire 10 :

| Mode de lecture | condition | VRBL | VBL | VBLB |
|---|---|---|---|---|
| 1^{er} mode | V_{read}>Vth | 0 | V_{read} | V_{read} |
| 2^{nd} mode | V_{read}>Vth | 0 | V_{read} | ½ V_{read} |
| 3^{ème} mode | Vth < V_{read} <2xVth | 0 | ½ V_{read} | V_{read} |
| 4^{ème} mode | V_{read}>Vth | V_{read} | 0 | 0 |
| 5^{ème} mode | V_{read}>Vth | V_{read} | 0 | ½ V_{read} |
| 6^{ème} mode | Vth < V_{read} <2xVth | V_{read} | ½ V_{read} | 0 |

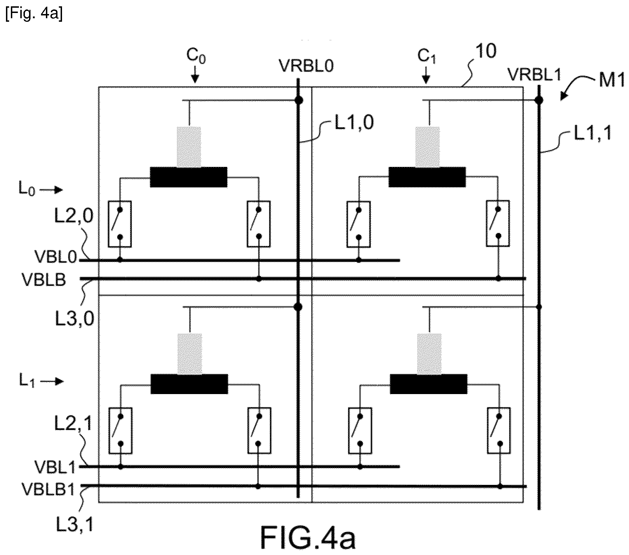

La figure 4a illustre un schéma électrique d'une matrice mémoire M1 utilisée dans le circuit mémoire D1 selon un premier mode de réalisation de l'invention.

La matrice mémoire M1 est formée par une pluralité de cellules mémoire 10 selon l'invention arrangées en lignes Lᵢ et colonnes Cₖ, i=0 à N et k=0 à M. A titre illustratif et non limitatif, la matrice M1 est formée par deux lignes L₀, L₁ et deux colonnes C₀ et C₁.

Les extrémités des jonctions tunnel magnétique MTJ des cellules mémoires 10 appartenant à la même colonne Cₖ de la matrice mémoire M1 sont interconnectés via une première ligne conductrice L1,k destinée à propager la première tension de commande VRBLₖ associée à ladite colonne Cₖ. Les premières électrodes EL1 des cellules mémoires 10 appartenant à la même ligne Lᵢ de la matrice mémoire M1 sont interconnectés via une seconde ligne conductrice L2,i destinée à propager la seconde tension de commande VBLᵢ associée à ladite ligne. Les secondes électrodes EL2 des cellules mémoires 10 appartenant à la même ligne de la matrice mémoire M1 sont interconnectées via une troisième ligne conductrice L3,i destinée à propager la troisième tension de commande VBLBᵢ associée.

Cette architecture matricielle est compatible avec le premier et le second mode d'écriture préalablement décrits et avec les six modes de lectures préalablement décrit.

Le tableau 3 illustre l'application des deux modes d'écriture asynchrones préalablement décrits à l'architecture de la matrice de cellules mémoire M1.

| | | Cellule sélectionnée | | | Cellules non-sélectionnées | | |
|---|---|---|---|---|---|---|---|
| Mode d'écriture | État logique | VRBL | VBL | VBLB | VRBL | VBL | VBLB |
| 1^{er} mode | 0 | 0 | V_{prog} | 0 | ½ V_{prog} | 0 | 0 |
| 1^{er} mode | 1 | 0 | 0 | V_{prog} | ½ V_{prog} | 0 | 0 |
| 2^{nd} **mode** | 0 | V_{prog} | V_{prog} | 0 | ½ V_{prog} | V_{prog} | V_{prog} |
| 2^{nd} mode | 1 | V_{prog} | 0 | V_{prog} | ½ V_{prog} | V_{prog} | V_{prog} |

Le tableau 4 illustre l'application des six modes de lecture préalablement décrits à l'architecture de la matrice de cellules mémoire M1.

| | Cellule sélectionnée | | | Cellules non-sélectionnées | | |
|---|---|---|---|---|---|---|
| Mode de lecture | VRBL | VBL | VBLB | VRBL | VBL | VBLB |
| 1^{er} mode | 0 | V_{read} | V_{read} | ½ V_{read} | 0 | 0 |
| 2^{nd} mode | 0 | V_{read} | ½ V_{read} | ½ V_{read} | 0 | 0 |
| 3^{ème} mode | 0 | ½ V_{read} | V_{read} | ½ V_{read} | 0 | 0 |
| 4^{ème} mode | V_{read} | 0 | 0 | ½ V_{read} | V_{read} | V_{read} |
| 5^{ème} mode | V_{read} | 0 | ½ V_{read} | ½ V_{read} | ½ V_{read} | ½ V_{read} |
| 6^{ème} mode | V_{read} | ½ V_{read} | 0 | ½ V_{read} | ½ V_{read} | ½ V_{read} |

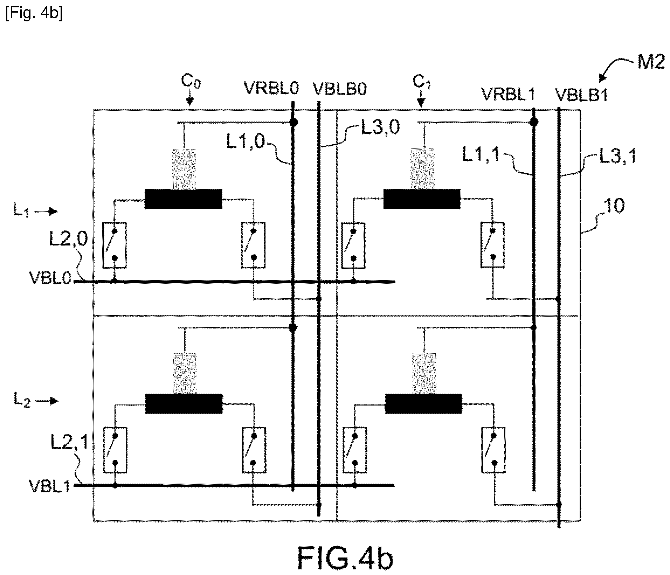

La figure 4b illustre un schéma électrique d'une matrice mémoire utilisée dans le circuit mémoire selon un deuxième mode de réalisation de l'invention.

La matrice mémoire M2 est formée par une pluralité de cellules mémoire 10 selon l'invention arrangées en lignes Lᵢ et colonnes Cₖ, i=0 à N et k=0 à M. A titre illustratif et non limitatif, la matrice M1 est formée par 2 lignes L₀, L₁ et 2 colonnes C₀ et C₁.

Les extrémités des jonctions tunnel magnétique MTJ des cellules mémoires 10 appartenant à la même colonne Cₖ de la matrice mémoire M1 sont interconnectés via une première ligne conductrice L1,k destinée à propager la première tension de commande VRBLₖ associée à ladite colonne Cₖ. Les premières électrodes EL1 des cellules mémoires 10 appartenant à la même ligne Lᵢ de la matrice mémoire M1 sont interconnectés via une seconde ligne conductrice L2,i destinée à propager la seconde tension de commande VBLᵢ associée à ladite ligne. Les secondes électrodes EL2 des cellules mémoires 10 appartenant à la même colonne Cₖ de la matrice mémoire M1 sont interconnectées via une troisième ligne conductrice L3,k destinée à propager la troisième tension de commande VBLBₖ associée.

Cette architecture matricielle est compatible avec le premier mode d'écriture préalablement décrit pour écrire un premier état logique « 0 », avec le second mode d'écriture préalablement décrit pour écrire l'état logique complémentaire « 1 », et avec les six modes de lectures préalablement décrits.

Le tableau 5 illustre l'application du premier mode d'écriture asynchrone préalablement décrits à l'architecture de la matrice de pixel M2.

| | | Cellule sélectionnée | | | Cellules non-sélectionnées | | |
|---|---|---|---|---|---|---|---|
| Mode d'écriture | État logique | VRBL | VBL | VBLB | VRBL | VBL | VBLB |
| 1^{er} mode | 0 | 0 | V_{prog} | 0 | ½ V_{prog} | 0 | 0 |
| 2ème mode | 1 | V_{prog} | 0 | V_{prog} | ½ V_{prog} | ½ V_{prog} | ½ V_{prog} |

Le tableau 6 illustre l'application du deuxième et le cinquième mode de lecture préalablement décrits à l'architecture de la matrice de pixel M2.

| | Cellule sélectionnée | | | Cellules non-sélectionnées | | |
|---|---|---|---|---|---|---|
| Mode de lecture | VRBL | VBL | VBLB | VRBL | VBL | VBLB |
| 2^{nd} mode | 0 | V_{read} | ½ V_{read} | ½ V_{read} | 0 | 0 |
| 5^{ème} mode | V_{read} | 0 | ½ V_{read} | ½ V_{read} | ½ V_{read} | ½ V_{read} |

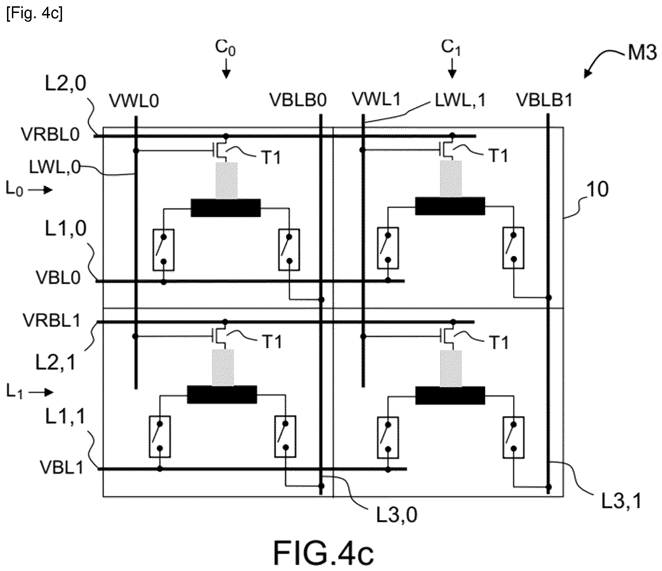

La figure 4c illustre un schéma électrique d'une matrice mémoire utilisée dans le circuit mémoire selon un troisième mode de réalisation de l'invention. La matrice mémoire M3 est formée par une pluralité de cellules mémoire 10 selon l'invention arrangées en lignes Lᵢ et colonnes Cₖ, i=0 à N et k=0 à M. À titre illustratif et non limitatif, la matrice M1 est formée par 2 lignes L₀, L₁ et 2 colonnes C₀ et C₁. Chaque cellule mémoire comprend en outre un transistor de commande T1. La source du transistor de commande T1 est connectée à l'extrémité supérieure de la jonction tunnel magnétique MTJ. La grille de chaque transistor T1 est commandée par un signal de sélection VWL généré par le circuit de contrôle CONT.

Les grilles des transistors de commande T1 des cellules mémoires 10 appartenant à la même colonne Cₖ de la matrice mémoire M3 sont interconnectées via une ligne conductrice LWL,k destinée à propager un signal de sélection VWLₖ associé. Les drains des transistors de commande T1 des cellules mémoires 10 appartenant à la même ligne Lᵢ de la matrice mémoire M3 sont interconnectés via une ligne conductrice L2,i destinée à propager la première tension de commande VRBL,i associée . Les premières électrodes EL1 des cellules mémoires 10 appartenant à la même ligne Lᵢ de la matrice mémoire M3 sont interconnectées via une seconde ligne conductrice L1,i destinée à propager la seconde tension de commande VBLᵢ associée à ladite ligne. Les secondes électrodes EL2 des cellules mémoires 10 appartenant à la même colonne Cₖ de la matrice mémoire M3 sont interconnectées via une ligne conductrice L3,i destinée à propager la troisième tension de commande VBLBₖ associée.

L'intégration des transistors de sélection T1 dans les cellules mémoires permet d'isoler les cellules mémoire non-sélectionnées pour une opération de lecture ou d'écriture en imposant une tension nulle à la grille du transistor de sélection T1. La sélection d'une cellule mémoire pour lecture ou écriture est réalisée par l'application de la tension d'alimentation VDD à la grille du transistor T1 associée à ladite cellule mémoire. La matrice mémoire M3 selon le troisième mode de réalisation est compatible avec les trois modes d'écriture (asynchrone et synchrone) et les six modes de lecture préalablement décrits.

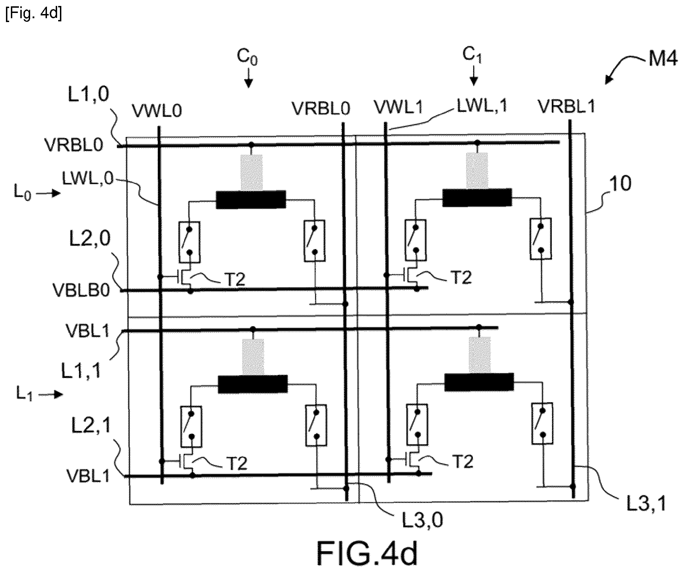

La figure 4d illustre un schéma électrique d'une matrice mémoire utilisée dans le circuit mémoire selon un quatrième mode de réalisation de l'invention.

La matrice mémoire M4 est formée par une pluralité de cellules mémoire 10 selon l'invention arrangées en lignes Lᵢ et colonnes Cₖ, i=0 à N et k=0 à M. À titre illustratif et non limitatif, la matrice M4 est formée par 2 lignes L₀, L₁ et 2 colonnes C₀ et C₁. Chaque cellule mémoire comprend en outre un transistor d'atténuation T2. Le drain dudit transistor d'atténuation T2 est connecté à la première électrode EL1. La grille de chaque transistor T2 est commandée par un signal de sélection VWL généré par le circuit de contrôle CONT.

Les grilles des transistors d'atténuation T2 des cellules mémoires 10 appartenant à la même colonne Cₖ de la matrice mémoire M4 sont interconnectées via une ligne conductrice LWL,k destinée à propager le signal de sélection VWLₖ associé. Les sources des transistors d'atténuation T2 des cellules mémoires 10 appartenant à la même ligne Lᵢ de la matrice mémoire M4 sont interconnectées via une ligne conductrice L2,i destinée à propager la deuxième tension de commande VBL,i associée. Les extrémités supérieures des piliers MTJ des cellules mémoires 10 appartenant à la même ligne Lᵢ de la matrice mémoire M4 sont interconnectées via une ligne conductrice L1,i destinée à propager la première tension de commande VRBLᵢ associée à ladite ligne. Les secondes électrodes EL2 des cellules mémoires 10 appartenant à la même colonne Cₖ de la matrice mémoire M4 sont interconnectées via une ligne conductrice L3,i destinée à propager la troisième tension de commande VBLBₖ associée.

L'intégration des transistors d'atténuation T2 dans les cellules mémoires permet d'isoler les cellules mémoire non-sélectionnées pour une opération de lecture ou d'écriture en imposant une tension nulle à la grille du transistor d'atténuation T2. La sélection d'une cellule mémoire pour lecture ou écriture est réalisée par l'application de la tension d'alimentation VDD à la grille du transistor T2 associé à ladite cellule mémoire. De plus, la modulation de la tension appliquée à la grille du transistor d'atténuation T2 permet d'atténuer l'amplitude du courant d'écriture et/ou de lecture de manière à améliorer la robustesse technique de la cellule mémoire et éviter les écritures accidentelles. La matrice mémoire M4 selon le quatrième mode de réalisation est compatible avec les trois modes d'écriture (asynchrone et synchrone) et les six modes de lecture préalablement décrits.

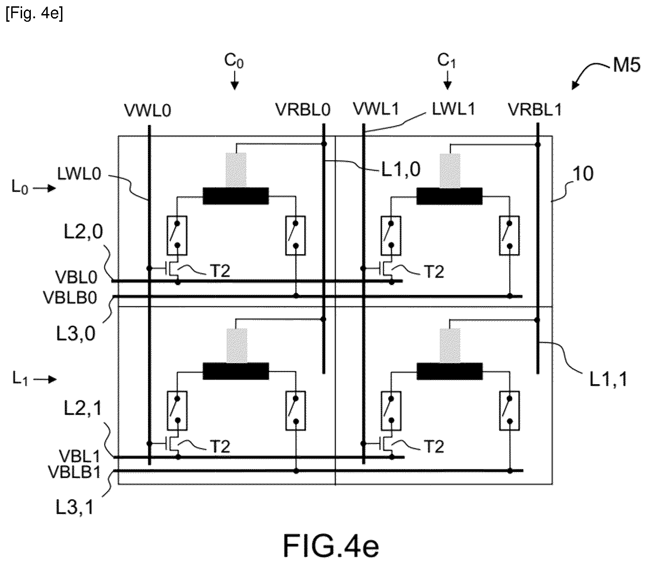

La figure 4e illustre un schéma électrique d'une matrice mémoire utilisée dans le circuit mémoire selon un cinquième mode de réalisation de l'invention.

La matrice mémoire M5 selon le cinquième mode de réalisation reprend les mêmes caractéristiques et avantages de la matrice mémoire selon le quatrième mode de réalisation. La matrice mémoire M5 se distingue de la matrice mémoire M4 par une interversion entre d'une part la ligne conductrice destinée à propager la première tension de commande VRBL (commune à des cellules d'une même colonne dans M5) et d'autre part la ligne conductrice destinée à propager la troisième tension de commande VBLB (commune à des cellules d'une même ligne dans M5)

La matrice mémoire M5 selon le cinquième mode de réalisation est compatible avec les trois modes d'écriture (asynchrone et synchrone) et les six modes de lecture préalablement décrits.

### Références

[1] : Rana Alhalabi, Etienne Nowak, loan-Lucian Prejbeanu, Gregory Di Pendina. High density SOTMRAM memory array based on a single transistor. Non-Volatile Memory Technology Symposium (NVMTS), Oct 2018, Sendai, Japan.

## Revendications

1. Cellule mémoire (10) magnéto-résistive comprenant :
- un pilier (MTJ) formant une jonction tunnel magnétique (MTJ) et ayant une extrémité supérieure destinée à recevoir une première tension de commande (VRBL) et une extrémité inférieure ;
- une piste d'écriture (SOT) en un matériau à effet Hall de spin ou un matériau à effet Hall orbital ; le pilier (MTJ) étant disposé sur ladite piste d'écriture du côté de son extrémité inférieure ;
- une couche support (14) en un matériau présentant une transition métal-isolant configurable ; la couche support (14) ayant une première face (141) et une seconde face opposée (142) ; la piste d'écriture (SOT) étant disposée sur ladite première face (141) ;
- une première électrode (EL1) disposée sur ladite seconde face (142) et destinée à recevoir une seconde tension de commande (VBL) ; la partie (143) de la couche support (14) confinée entre la première électrode (EL1) et la piste d'écriture (SOT) présentant un état de conduction configurable par la première et la seconde tension de commande (VRBL, VBL) de manière à former un premier sélecteur (S1) ayant un état résistif haut (R1_{OFF}) et un état résistif bas (R1_{ON}) ;
- une seconde électrode (EL2) disposée sur ladite seconde face (142) et destinée à recevoir une troisième tension de commande (VBLB) ; la partie (144) de la couche support (14) confinée entre la seconde électrode (EL2) et la piste d'écriture (SOT) présentant un état de conduction configurable par la première et la troisième tension de commande (VRBL, VBLB) de manière à former un second sélecteur (S2) ayant un état résistif haut (R2_{OFF}) et un état résistif bas (R2_{ON}).

2. Cellule mémoire (10) magnéto-résistive selon la revendication 1 dans laquelle la couche support (14) est en oxyde de Mott ou un isolant topologique.

3. Cellule mémoire (10) magnéto-résistive selon la revendication 2 dans laquelle au moins l'une des parties confinées (143,144) de la couche support (14) est dopée par le chrome ou par le tungstène ou par le titane ou par l'aluminium ou par le fer ou par le molybdène ou par le tantale ou par le ruthénium ou par le zirconium.

4. Cellule mémoire (10) magnéto-résistive selon l'une quelconque des revendications 1 à 3 dans laquelle la piste d'écriture (SOT) est réalisée en un matériau à effet Hall de spin choisi parmi du tungstène en phase béta ou de l'antimoniure de bismuth ou un alliage BiSbTe.

5. Cellule mémoire (10) magnéto-résistive selon l'une quelconque des revendications 1 à 3 dans laquelle la piste d'écriture (SOT) est réalisée en un matériau à effet Hall Orbital choisi parmi en chrome ou le zirconium ou le titane ou le vanadium ou le cuivre ou le manganèse ou le molybdène ou le ruthénium ou l'aluminium ou le niobium ou le tungstène en phase alpha.

6. Cellule mémoire (10) magnéto-résistive selon l'une quelconque des revendications 1 à 5 dans laquelle la piste d'écriture (SOT) présente une épaisseur inférieure ou égale à 20 nm.

7. Cellule mémoire (10) magnéto-résistive selon l'une quelconque des revendications 1 à 6 dans laquelle le premier et/ou le second sélecteur (S1, S2) présente une résistance supérieure ou égale à 10 fois la résistance de la piste d'écriture (SOT) lorsque ledit sélecteur (S1, S2) est à un état résistif haut (R1_{OFF} , R2_{OFF}).

8. Cellule mémoire (10) magnéto-résistive selon l'une quelconque des revendications 1 à 7 dans laquelle le premier et/ou le second sélecteur (S1, S2) présente une résistance supérieure ou égale à 10 fois la résistance de la jonction tunnel magnétique (MTJ ) lorsque ledit sélecteur (S1, S2) est à un état résistif haut (R1_{OFF} , R2_{OFF}).

9. Cellule mémoire (10) magnéto-résistive selon l'une quelconque des revendications 1 à 8 dans laquelle le premier et/ou le second sélecteur (S1, S2) présente une résistance inférieure ou égale à la résistance de la piste d'écriture (SOT) lorsque ledit sélecteur (S1, S2) est à un état résistif bas (R1_{ON} , R2_{ON}).

10. Cellule mémoire (10) magnéto-résistive selon l'une quelconque des revendications 1 à 9 dans laquelle le premier et/ou le second sélecteur (S1, S2) présente une résistance inférieure ou égale à un dixième de la résistance de la jonction tunnel magnétique (MTJ ) lorsque ledit sélecteur (S1, S2) est à un état résistif bas (R1_{ON} , R2_{OFF}).

11. Cellule mémoire (10) magnéto-résistive selon l'une quelconque des revendications 1 à 10 comprenant en outre un transistor de commande (T1) ; la source dudit transistor de commande (T1) étant connectée à l'extrémité supérieure du pilier (MTJ).

12. Cellule mémoire (10) magnéto-résistive selon l'une quelconque des revendications 1 à 11 comprenant en outre un transistor d'atténuation (T2) ; le drain dudit transistor d'atténuation (T2) étant connecté à la première électrode (EL1).

13. Cellule mémoire (10) magnéto-résistive selon l'une quelconque des revendications 1 à 12 dans laquelle le premier et/ou le second sélecteur (S1, S2) est adapté pour passer d'un état résistif haut (R1_{OFF} , R2_{OFF}) à un état résistif bas (R1_{ON} , R2_{ON}) lorsque l'amplitude de la tension aux bornes dudit sélecteur est supérieure à une tension de seuil prédéterminée (Vth).

14. Circuit mémoire (D1) comprenant :
- une matrice mémoire (Mx) formée par une pluralité de cellules mémoire (10) selon la revendication 13 ;
- un circuit de contrôle (CONT) configuré pour générer la première tension de commande (VRBL), la seconde tension de commande (VBL) et la troisième tension de commande (VBLB).

15. Circuit mémoire (D1) selon la revendication 14 dans lequel le circuit de contrôle (CONT) est configuré pour réaliser une opération d'écriture sur une cellule mémoire (10) de la matrice (Mx) en lui appliquant :
- une première tension de commande (VRBL) nulle, une seconde tension de commande (VBL) supérieure à la tension de seuil prédéterminée (Vth) et une troisième tension de commande (VBLB) nulle pour écrire un premier état logique ;
- une première tension de commande (VRBL) nulle, une seconde tension de commande (VBL) nulle et une troisième tension de commande (VBLB) supérieure à la tension de seuil prédéterminée (Vth) pour écrire un second état logique complémentaire au premier état logique.

16. Circuit mémoire (D1) selon la revendication 14 dans lequel le circuit de contrôle (CONT) est configuré pour réaliser une opération d'écriture sur une cellule mémoire (10) de la matrice (Mx) en lui appliquant :
- une première tension de commande (VRBL) supérieure à la tension de seuil prédéterminée (Vth), une seconde tension de commande (VBL) égale à la première tension de commande (VRBL) et une troisième tension de commande (VBLB) nulle pour écrire un premier état logique ;
- une première tension de commande (VRBL) supérieure à la tension de seuil prédéterminée (Vth), une seconde tension de commande (VBL) nulle et une troisième tension de commande (VBLB) égale à la première tension de commande (VRBL) pour écrire un second état logique complémentaire au premier état logique.

17. Circuit mémoire (D1) selon la revendication 14 dans lequel le circuit de contrôle (CONT) est configuré pour réaliser une opération d'écriture sur une cellule mémoire (10) de la matrice (Mx) en lui appliquant :
- une seconde tension de commande (VBL) supérieure au double de la tension de seuil prédéterminée (Vth) ; une première tension de commande (VRBL) égale à la moitié de la seconde tension de commande (VBL) et une troisième tension de commande (VBLB) nulle pour écrire un premier état logique ;
- une troisième tension de commande (VBLB) supérieure au double de la tension de seuil prédéterminée (Vth) ; une première tension de commande (VRBL) égale à la moitié de la troisième tension de commande (VBL) et une seconde tension de commande (VBL) nulle pour écrire un second état logique complémentaire au premier état logique.

18. Circuit mémoire (D1) selon la revendication 14 dans lequel le circuit de contrôle (CONT) est configuré pour réaliser une opération de lecture d'une cellule mémoire (10) de la matrice mémoire (Mx) en lui appliquant une seconde et une troisième tension de commande (VBL, VBLB) supérieures à la tension de seuil prédéterminée (Vth) et une première tension de commande (VRBL) nulle.

19. Circuit mémoire (D1) selon la revendication 14 dans lequel :
- les extrémités supérieures des piliers (MTJ) des cellules mémoires (10) appartenant à la même colonne de la matrice mémoire (M1) sont interconnectées via une première ligne conductrice (L1,0 ; L1,1) destinée à propager la première tension de commande (VRBL₀ VRBL₁) associée ;
- les premières électrodes (EL1) des cellules mémoires (10) appartenant à la même ligne de la matrice mémoire (M1) sont interconnectées via une seconde ligne conductrice (L2,0 ; L2,1) destinée à propager la seconde tension de commande (VBL₀, VBL₁) associée ;
- les secondes électrodes (EL2) des cellules mémoires (10) appartenant à la même ligne de la matrice mémoire (M1) sont interconnectées via une troisième ligne conductrice (L3,0 ; L3.1) destinée à propager la troisième tension de commande (VBLB₀, VBLB₁ ) associée.

20. Circuit mémoire (D1) selon la revendication 14 dans lequel :
- les extrémités supérieures des piliers (MTJ) des cellules mémoires (10) appartenant à la même colonne de la matrice mémoire (M2) sont interconnectées via une première ligne conductrice (L1,0 ; L1,1) destinée à propager la première tension de commande (VRBL₀ VRBL₁) associée ;
- les premières électrodes (EL1) des cellules mémoires (10) appartenant à la même ligne de la matrice mémoire (M2) sont interconnectées via une seconde ligne conductrice (L2,0 ; L2,1) destinée à propager la seconde tension de commande (VBL₀, VBL₁) associée ;
- les secondes électrodes (EL2) des cellules mémoires (10) appartenant à la même colonne de la matrice mémoire (M2) sont interconnectées via une troisième ligne conductrice (L3,0 ; L3.1) destinée à propager la troisième tension de commande (VBLB₀, VBLB₁) associée ;

21. Circuit mémoire (D1) selon la revendication 14 en combinaison avec la revendication 11 dans lequel :
- les grilles des transistors de commande (T1) des cellules mémoires (10) appartenant à la même colonne de la matrice mémoire (M3) sont interconnectées via une première ligne conductrice (LWL,0 ; LWL,1) destinée à propager un signal de sélection (VWL₀, VWL₁) associée ;
- les drains des transistors de commande (T1) des cellules mémoires (10) appartenant à la même ligne de la matrice mémoire (M3) sont interconnectés via une seconde ligne conductrice (L2,0 ; L2,1) destinée à propager la première tension de commande (VRBL₀, VRBL₁) associée ;
- les premières électrodes (EL1) des cellules mémoires (10) appartenant à la même ligne de la matrice mémoire (M3) sont interconnectées via une troisième ligne conductrice (L1,0 ; L1,1) destinée à propager la seconde tension de commande (VBL₀ , VBL₁) associée ;
- les secondes électrodes (EL2) des cellules mémoires (10) appartenant à la même colonne de la matrice mémoire (M3) sont interconnectées via une quatrième ligne conductrice (L3,0 ; L3,1) destinée à propager la troisième tension de commande (VBLB₀, VBLB₁) associée ;

22. Circuit mémoire (D1) selon la revendication 14 en combinaison avec la revendication 12 dans lequel :
- les extrémités supérieures des piliers (MTJ) des cellules mémoire (10) appartenant à la même ligne de la matrice mémoire (M4) sont interconnectées via une première ligne conductrice (L1,0 ; L1,1) destinée à propager la première tension de commande (VRBL₀, VRBL₁) associée ;
- les sources des transistors d'atténuation (T2) des cellules mémoire (10) appartenant à la même ligne de la matrice mémoire (M4) sont interconnectées via une seconde ligne conductrice (L2,0 ; L2,1) destinée à propager la seconde tension de commande (VBL₀ ; VBL₁) associée ;
- les secondes électrodes (EL2) des cellules mémoire (10) appartenant à la même colonne de la matrice mémoire (M4) sont interconnectées via une troisième ligne conductrice (L3,0 ; L3,1) destinée à propager la troisième tension de commande (VBLB₀, VBLB₁) associée ;
- les grilles des transistors d'atténuation (T2) des cellules mémoire (10) appartenant à la même colonne de la matrice mémoire (M4) sont interconnectées via une quatrième ligne conductrice (LWL0 ; LWL1) destinée à propager un signal de sélection (VWL₀, VWL₁) associé ;

23. Circuit mémoire (D1) selon la revendication 14 en combinaison avec la revendication 12 dans lequel :
- les extrémités supérieures des piliers (MTJ) des cellules mémoire (10) appartenant à la même colonne de la matrice mémoire (M5) sont interconnectées via une première ligne conductrice (L1,0 ; L1,1) destinée à propager la première tension de commande (VRBL₀ ; VRBL₁) associée ;
- les sources des transistors d'atténuation (T2) des cellules mémoires (10) appartenant à la même ligne de la matrice mémoire (M5) sont interconnectées via une seconde ligne conductrice (L2,0 ; L2,1) destinée à propager la seconde tension de commande (VBL₀ ; VBL₁) associée ;
- les secondes électrodes (EL2) des cellules mémoires (10) appartenant à la même ligne de la matrice mémoire (M3) sont interconnectées via une troisième ligne conductrice (L3,0 ; L3,1) destinée à propager la troisième tension de commande (VBLB₀, VBLB₁) associée ;
- les grilles des transistors de commande (T2) des cellules mémoires (10) appartenant à la même colonne de la matrice mémoire (M3) sont interconnectées via une quatrième ligne conductrice (LWL0 ; LWL1) destinée à propager un signal de sélection (VWL₀, VWL₁) associé.
